# DEMANDE DE BREVET EUROPEEN

(11) **EP 0 905 893 A1**
(43) Date de publication de la demande: **31.03.1999**
(21) Numéro de dépôt: 98410110.5
(22) Date de dépôt: 29.09.1998
(51) Int. Cl.: H03K 3/356

(54) **Bascule à transparence commandée fonctionnant avec un signal d'horloge de faible excursion**

(30) Priorité: 30.09.1997 FR 9712390
(71) Demandeur: STMicroelectronics SA, 94250 Gentilly Cedex (FR)
(72) Inventeur: Schoellkopf, Jean-Pierre, 38000 Grenoble (FR)
(74) Mandataire: de Beaumont, Michel

(57) **Abrégé**

L'invention concerne une bascule à transparence commandée comprenant deux premiers transistors (MN3, MN4) à canal N connectés à un potentiel d'alimentation bas (Vss) et commandés par un signal d'horloge (CK) ; deux deuxièmes transistors (MN5, MN6) reliant respectivement les deux premiers transistors à une borne de sortie inversée (Q/) et à une borne de sortie non-inversée (Q) et commandés respectivement par une ligne de donnée (D) et une ligne de donnée complémentaire (D/) ; deux troisièmes transistors (MP3, MP4) à canal P couplant respectivement les deux deuxièmes transistors à un potentiel d'alimentation haut (Vdd) et commandés de manière croisée par les bornes de sortie (Q, Q/) ; et des moyens pour maintenir les états des bornes de sortie lorsque les premiers transistors sont non-conducteurs.

## Description

La présente invention concerne une bascule à transparence commandée (latch), c'est-à-dire une bascule qui, pour un premier état d'un signal d'horloge, transmet intégralement une donnée présentée à son entrée et, pour un deuxième état du signal d'horloge, mémorise ou verrouille le dernier état de la donnée. La présente invention vise plus particulièrement une telle bascule pouvant fonctionner avec un signal d'horloge de faible excursion dans le but de réduire la puissance consommée par la distribution du signal d'horloge.

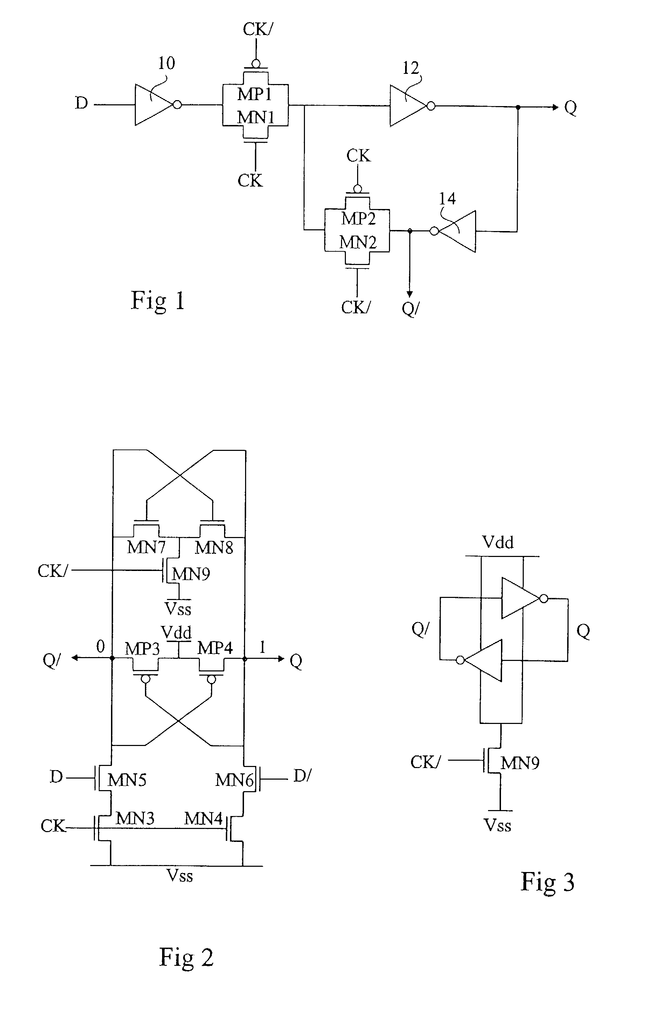

La figure 1 représente une bascule à transparence commandée classique. La donnée D est appliquée sur l'entrée d'un inverseur 10 dont la sortie est couplée à l'entrée d'un inverseur 12 par l'intermédiaire d'un interrupteur constitué de l'association en parallèle d'un transistor MOS à canal N MN1 et d'un transistor MOS à canal P MP1. Le transistor MN1 est commandé par un signal d'horloge CK, tandis que le transistor MP1 est commandé par le complément CK/ de ce signal d'horloge. La sortie de l'inverseur 12 constitue la sortie Q de la bascule. Cette sortie Q est par ailleurs reliée à l'entrée d'un inverseur 14 dont la sortie constitue une sortie complémentaire Q/ de la bascule. Cette sortie Q/ est reliée à l'entrée de l'inverseur 12 par l'intermédiaire d'un interrupteur constitué de l'association en parallèle d'un transistor MOS à canal N MN2 et d'un transistor MOS à canal P MP2. Le transistor MN2 est commandé par le signal d'horloge complémentaire CK/ tandis que le transistor MN2 est commandé par le signal d'horloge CK.

On prévoit deux types de transistors dans chaque interrupteur, car seul un conduira convenablement en fonction du niveau du signal à transmettre. Plus spécifiquement, le transistor à canal P transmettra les niveaux hauts du signal, et le transistor à canal N transmettra les niveaux bas.

Lorsque le signal d'horloge CK est à l'état haut, l'interrupteur MN1-MP1 est passant alors que l'interrupteur MN2-MP2 est bloqué. L'état de la donnée D est alors transmis tel quel vers la sortie Q par l'intermédiaire des inverseurs 10 et 12.

Lorsque le signal d'horloge CK est à l'état bas, l'interrupteur MN1-MP1 est bloqué tandis que l'interrupteur MN2-MP2 est passant. L'inverseur 10 est déconnecté de l'entrée de l'inverseur 12 tandis que les inverseurs 12 et 14 sont connectés tête-bêche pour constituer un point mémoire qui mémorise l'état qu'avait le signal D au moment où l'horloge CK est passée à l'état bas.

La puissance consommée pour distribuer le signal d'horloge est proportionnelle à CFV², C étant la capacité de la ligne d'horloge, F la fréquence du signal d'horloge et V la tension crête à crête, ou excursion, du signal d'horloge. Les circuits intégrés devenant de plus en plus grands et fonctionnant à des fréquences de plus en plus élevées, la puissance consommée pour la distribution du signal d'horloge devient importante.

Dans des circuits récents, on cherche à utiliser un signal d'horloge ayant une excursion nettement inférieure à la tension d'alimentation nominale du circuit, ce qui réduit considérablement la puissance consommée, puisque la puissance s'exprime en fonction du carré de l'excursion du signal d'horloge. Par exemple, pour des circuits fonctionnant à une tension nominale de 3,3 ou 2,5 volts, on utilise un signal d'horloge variant entre 0 et 1 volt, ce qui réduit la puissance consommée d'un facteur 10 ou 6, respectivement.

Toutefois, certains circuits, notamment les bascules du type de la figure 1, ne peuvent pas fonctionner avec un signal d'horloge variant entre 0 et 1 volt. En effet, la valeur maximale de 1 volt du signal d'horloge CK ou CK/ est trop éloignée de la tension d'alimentation nominale pour bloquer les transistors MOS à canal P MP1 et MP2. En conséquence, lorsque le signal d'horloge CK est à l'état bas et que l'interrupteur MN1-MP1 est supposé être bloqué, le transistor MP1 est malgré tout susceptible de laisser passer un niveau haut qui risque de faire basculer le point mémoire constitué des inverseurs 12 et 14. Par ailleurs, les transistors à canal N MN1 et MN2, commandés par une tension proche de leur tension seuil, sont peu conducteurs et peuvent même ne pas être rendus conducteurs si leurs sources sont à un potentiel résiduel supérieur au potentiel d'alimentation bas. Ceci risque notamment de se produire dans le cas de la figure 1 où les sources des transistors MN1 et MN2 sont reliées au potentiel bas par l'intermédiaire de transistors constituant les inverseurs 10 et 14.

Un objet de la présente invention est de prévoir une bascule à transparence commandée qui puisse fonctionner avec une horloge à faible excursion.

Cet objet est atteint grâce à une bascule à transparence commandée comprenant deux premiers transistors de premier type de conductivité connectés à un premier potentiel d'alimentation et commandés par un signal d'horloge ; deux deuxièmes transistors reliant respectivement les deux premiers transistors à une borne de sortie inversée et à une borne de sortie non-inversée et commandés respectivement par une ligne de donnée et une ligne de donnée complémentaire ; deux troisièmes transistors de deuxième type de conductivité couplant respectivement les deux deuxièmes transistors à un deuxième potentiel d'alimentation et commandés de manière croisée par les bornes de sortie ; et des moyens pour maintenir les états des bornes de sortie lorsque les premiers transistors sont non-conducteurs.

Selon un mode de réalisation de la présente invention, lesdits moyens comprennent deux quatrièmes transistors de premier type de conductivité reliant respectivement les bornes de sortie au premier potentiel d'alimentation par l'intermédiaire d'un cinquième transistor de premier type de conductivité, et commandés de manière croisée par les bornes de sortie, le cinquième transistor étant commandé par un signal d'horloge inversé.

Selon un mode de réalisation de la présente invention, la conductivité à l'état passant des troisièmes transistors est plus faible que celle de l'association série de l'un des premiers transistors et de l'un des deuxièmes transistors.

Selon un mode de réalisation de la présente invention, le premier type de conductivité est N, le premier potentiel d'alimentation est un potentiel bas, le deuxième potentiel d'alimentation est un potentiel haut, et le niveau du signal d'horloge varie entre le potentiel d'alimentation bas et un niveau inférieur au potentiel d'alimentation haut.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, précédemment décrite, représente une bascule à transparence commandée classique ;
la figure 2 représente un mode de réalisation de bascule à transparence commandée selon la présente invention ; et
la figure 3 représente un schéma équivalent d'une partie de la bascule de la figure 2.

A la figure 2, une bascule à transparence commandée selon l'invention comprend deux transistors MOS à canal N MN3 et MN4 dont les sources sont directement connectées au potentiel d'alimentation bas Vss. Ces deux transistors sont commandés par un signal d'horloge CK. Deux transistors MOS à canal N MN5 et MN6 relient les transistors MN3 et MN4 respectivement à une borne de sortie inversée Q/ et à une borne de sortie non-inversée Q de la bascule. Les transistors MN5 et MN6 sont commandés respectivement par une donnée D et son complément D/. Les bornes de sortie Q/ et Q sont reliées au potentiel d'alimentation haut Vdd par l'intermédiaire de deux transistors respectifs MP3 et MP4 de type MOS à canal P. Les transistors MP3 et MP4 sont commandés de manière croisée par les sorties Q/ et Q, c'est-à-dire que la grille du transistor MP4 est reliée à la sortie Q/ tandis que la grille du transistor MP3 est reliée à la sortie Q.

On peut déjà comprendre le fonctionnement de la bascule sans considérer les éléments de la partie supérieure de la figure 2 qui seront décrits ultérieurement.

Lorsque le signal d'horloge CK est à l'état bas, les transistors MN3 et MN4 sont bloqués. Alors, celle des sorties Q et Q/ qui est à 0 est flottante et conserve son état par effet capacitif. Par exemple, la sortie Q/ est flottante et son état 0 est conservé par la capacité de grille du transistor MP4. La grille du transistor MP4 étant donc à 0, le transistor MP4 est conducteur et transmet le potentiel d'alimentation haut Vdd, c'est-à-dire l'état 1, à la sortie Q. Tant que les transistors MN3 et MN4 sont bloqués, l'état de la bascule ne peut être affecté par la donnée D ni son complément D/, c'est-à-dire que la bascule est à l'état verrouillé.

Lorsque le signal CK est à une valeur légèrement supérieure à la tension seuil des transistors MN3 et MN4, ces derniers deviennent conducteurs.

Dans ce cas, si la donnée D est à l'état 1, le transistor MN5 est conducteur et tire la sortie Q/ vers le potentiel Vss, c'est-à-dire vers l'état 0. Dans l'exemple, ceci n'a aucun effet sur l'état de la bascule. Le transistor MN6, recevant l'état 0 sur sa grille, est bloqué et ne peut affecter l'état de la sortie Q.

Si la donnée D est à l'état 0, le transistor MN5 est bloqué et le transistor MN6 devient conducteur et tire la sortie Q vers le potentiel Vss, ce qui affecte l'état 1 de la sortie Q dans l'exemple. Pour que l'état 1 de la sortie Q puisse être tiré vers 0, le transistor MP4 est dimensionné pour avoir une conductivité plus faible que celle de l'association en série des transistors MN6 et MN4. Dans ce cas, le potentiel de la sortie Q finit par décroître jusqu'à la tension seuil du transistor MP3 qui devient alors conducteur. Le transistor MP3 fait rapidement croître le potentiel de la sortie Q/ vers le potentiel Vdd, puisque la sortie Q/ était flottante. Le niveau de la sortie Q/ franchit rapidement le seuil du transistor MP4 qui se bloque et permet à la sortie Q d'être tirée vers le potentiel Vss sans empêchement.

Si l'état de la donnée D change de nouveau alors que le signal d'horloge CK est toujours à l'état haut, l'état de la bascule change également, ceci de manière symétrique à ce qui vient d'être décrit. En d'autres termes, tant que le signal d'horloge CK est à l'état haut, la bascule est transparente.

La bascule peut fonctionner convenablement avec un signal d'horloge d'excursion réduite, variant par exemple entre 0 et 1 volt, puisqu'on utilise un montage permettant cela au mieux (des transistors à canal N dont les sources sont directement reliées au potentiel d'alimentation bas Vss).

Avec les éléments qui viennent d'être décrits, lorsque la bascule est verrouillée sur un état, cet état est seulement conservé par effet capacitif. Des courants de fuite pourraient donc entraîner la modification de l'état de la bascule lorsque celle-ci reste verrouillée trop longtemps.

Pour éviter cela, on prévoit le circuit de la partie supérieure de la figure 2. Ce circuit comprend deux transistors MOS à canal N MN7 et MN8 reliés en série entre les sorties Q/ et Q. Les transistors MN7 et MN8 sont commandés de manière croisée, c'est-à-dire que la grille du transistor MN8 est reliée à la sortie Q/ et la grille du transistor MN7 est reliée à la sortie Q. Le point de connexion entre les transistors MN7 et MN8 est relié au potentiel bas Vss par un transistor MOS à canal N MN9 qui est commandé par le complément CK/ du signal d'horloge CK.

Lorsque la bascule est à l'état transparent, c'est-à-dire lorsque le signal d'horloge CK est à l'état haut, le transistor MN9 est bloqué. Il en résulte que les transistors MN7 et MN8 n'interviennent pas dans le fonctionnement qui vient d'être décrit.

Lorsque la bascule est l'état verrouillé, c'est-à-dire lorsque le signal CK est à l'état bas, le transistor MN9 devient conducteur. Si on considère de nouveau l'exemple où la sortie Q est à 1 et la sortie Q/ à 0, le transistor MN7 est conducteur tandis que le transistor MN8 est bloqué. Ainsi, la sortie Q/ est reliée au potentiel Vss par l'intermédiaire des transistors MN7 et MN9, ce qui confirme l'état 0 de cette sortie Q/. L'état 1 de la sortie Q est toujours confirmé par le transistor MP4. Les deux sorties de la bascule sont donc confirmées et aucune dérive par courant de fuite n'est possible.

Le signal CK/ peut être de faible excursion, comme le signal CK, car le type et le mode de connexion du transistor MN9 sont les plus appropriés pour cela.

La figure 3 représente un schéma équivalent de la partie supérieure de la bascule de la figure 2. Les transistors MP3, MP4, MN7 et MN8 constituent deux inverseurs reliés tête-bêche. Ces inverseurs sont alimentés directement par le potentiel haut Vdd et alimentés à partir du potentiel bas Vss par l'intermédiaire du transistor MN9.

## Revendications

1. Bascule à transparence commandée comprenant :
- deux premiers transistors (MN3, MN4) de premier type de conductivité connectés à un premier potentiel d'alimentation (Vss) et commandés par un signal d'horloge (CK) ;
- deux deuxièmes transistors (MN5, MN6) reliant respectivement les deux premiers transistors à une borne de sortie inversée (Q/) et à une borne de sortie non-inversée (Q) et commandés respectivement par une ligne de donnée (D) et une ligne de donnée complémentaire (D/) ;
- deux troisièmes transistors (MP3, MP4) de deuxième type de conductivité couplant respectivement les deux deuxièmes transistors à un deuxième potentiel d'alimentation (Vdd) et commandés de manière croisée par les bornes de sortie (Q, Q/) ; et
- des moyens pour maintenir les états des bornes de sortie lorsque les premiers transistors sont non-conducteurs.

2. Bascule selon la revendication 1, caractérisée en ce que lesdits moyens comprennent deux quatrièmes transistors (MN7, MN8) de premier type de conductivité reliant respectivement les bornes de sortie (Q, Q/) au premier potentiel d'alimentation (Vss) par l'intermédiaire d'un cinquième transistor (MN9) de premier type de conductivité, et commandés de manière croisée par les bornes de sortie, le cinquième transistor étant commandé par un signal d'horloge inversé (CK/).

3. Bascule selon la revendication 1 ou 2, caractérisée en ce que la conductivité à l'état passant des troisièmes transistors est plus faible que celle de l'association série de l'un des premiers transistors et de l'un des deuxièmes transistors.

4. Bascule selon l'une quelconque des revendications 1 à 3, caractérisée en ce que le premier type de conductivité est N, le premier potentiel d'alimentation est un potentiel bas (Vss), le deuxième potentiel d'alimentation est un potentiel haut (Vdd), et le niveau du signal d'horloge (CK) varie entre le potentiel d'alimentation bas (Vss) et un niveau inférieur au potentiel d'alimentation haut (Vdd).
